# FASCICULE DE BREVET EUROPEEN

(11) **EP 0 923 130 B1**
(45) Date de publication et mention de la délivrance du brevet: **11.07.2007**
(21) Numéro de dépôt: 98403144.3
(22) Date de dépôt: 14.12.1998
(51) Int. Cl.: H01L 23/538, H01L 23/485, H01L 25/16, H01L 25/065, H01L 21/58, H01L 23/498

(54) **Circuit électronique, notamment pour un dispositif médical implantable actif tel qu'un stimulateur ou défibrillateur cardiaque, et son procédé de réalisation**
Elektronische Schaltung, insbesondere für implantierbare aktive medizinische Vorrichtung, wie ein Herzstimulator oder -defibrillator, und deren Herstellungsmethode
Electronic circuit, in particular for implantable active medical device, like a heart stimulator or defibrillator, and its manufacturing method

(30) Priorité: 12.12.1997 FR 9715800
(43) Date de publication de la demande: 16.06.1999
(73) Titulaire: ELA MEDICAL (Société anonyme), 92541 Montrouge (FR)
(72) Inventeur: van Campenhout, Yves, 94190 Saint George (FR)
(74) Mandataire: Dupuis-Latour, Dominique

(56) Documents cités:
- EP-A- 0 384 704
- EP-A- 0 450 948
- EP-A- 0 465 196
- WO-A-81/02367
- WO-A-93/24956
- DE-A- 3 925 604
- FR-A- 2 599 893
- US-A- 5 177 594
- US-A- 5 434 751
- FILLION R A ET AL: "NON-DIGITAL EXTENSIONS OF AN EMBEDDED CHIP MCM TECHNOLOGY" INTERNATIONAL JOURNAL OF MICROCIRCUITS AND ELECTRONIC PACKAGING, vol. 17, no. 4, 1 octobre 1994, pages 392-399, XP000497401
- GDULA M ET AL: "A HIGH-SPEED, HIGH-DENSITY MULTIPROCESSING MODULE MADE WITH THE GENERAL ELECTRIC HIGH-DENSITY INTERCONNECT TECHNOLOGY" DIGITAL SIGNAL PROCESSING, vol. 2, no. 4, 1 octobre 1992, pages 247-251, XP000393639

## Description

La présente invention concerne la technologie des circuits électroniques, notamment des circuits électroniques de dispositifs médicaux implantables actifs tels que les stimulateurs ou défibrillateurs cardiaques.

En effet, dans ces domaines, la miniaturisation des circuits est un paramètre essentiel, et l'on se trouve souvent confronté à la difficulté consistant à trouver un compromis entre, d'une part, l'augmentation du nombre et de la taille des composants électroniques pour disposer d'appareils intégrant un plus grand nombre de fonctions et, d'autre part, la miniaturisation de plus en plus poussée du circuit, de manière à ne pas empiéter sur le volume nécessaire à la pile d'alimentation.

Jusqu'à présent, ces circuits sont habituellement réalisés sur un substrat double face portant les circuits intégrés incorporant les diverses puces encapsulées et les composants discrets passifs (condensateurs, résistances, etc.) et actifs (diodes).

Un circuit de ce type est par exemple décrit par le WO-A-93/24956, avec substrat multicouche comportant des motifs d'interconnexion.

L'un des buts de l'invention est de proposer une nouvelle technologie de réalisation d'un circuit électronique procurant un gain de place important, afin de pouvoir réduire les dimensions du circuit dans des proportions très importantes.

Un autre but de l'invention est la rationalisation du processus de fabrication des circuits, avec report direct sur le substrat de puces directement obtenues après découpe d'une tranche, sans traitement additionnel ni encapsulation.

Un autre but encore de l'invention est de permettre une plus grande densité d'intégration des composants discrets et une plus grande densité de routage des diverses interconnexions, en permettant l'utilisation de la surface déjà occupée par les puces pour l'adjonction de couches d'interconnexion supplémentaires et/ou de composants additionnels.

Le procédé de l'invention, qui est du type général divulgué par le WO-A-93/24956 correspondant au préambule de la revendication 1, met en oeuvre les étapes exposées à la partie caractérisante de cette revendication 1.

L'invention vise également, en tant que produit industriel nouveau, un circuit électronique correspondant, présentant la configuration exposée par la revendication 7. Les sous-revendications visent diverses formes avantageuses de mise en oeuvre de l'invention.

D'autres caractéristiques et avantages de l'invention apparaîtront à la lecture de la description détaillée ci-dessous d'un exemple de mise en oeuvre, en référence aux dessins annexés.
La figure 1 est une vue en coupe partielle d'un circuit double face réalisé selon les enseignements de l'invention.
La figure 2 est une vue agrandie du détail repéré II sur la figure 1.
Les figures 3 et 4 montrent à la même échelle, à titre de comparaison, le même circuit réalisé respectivement avec la technologie de l'art antérieur et avec celle de l'invention.
La figure 5 illustre une variante de mise en oeuvre de l'invention.

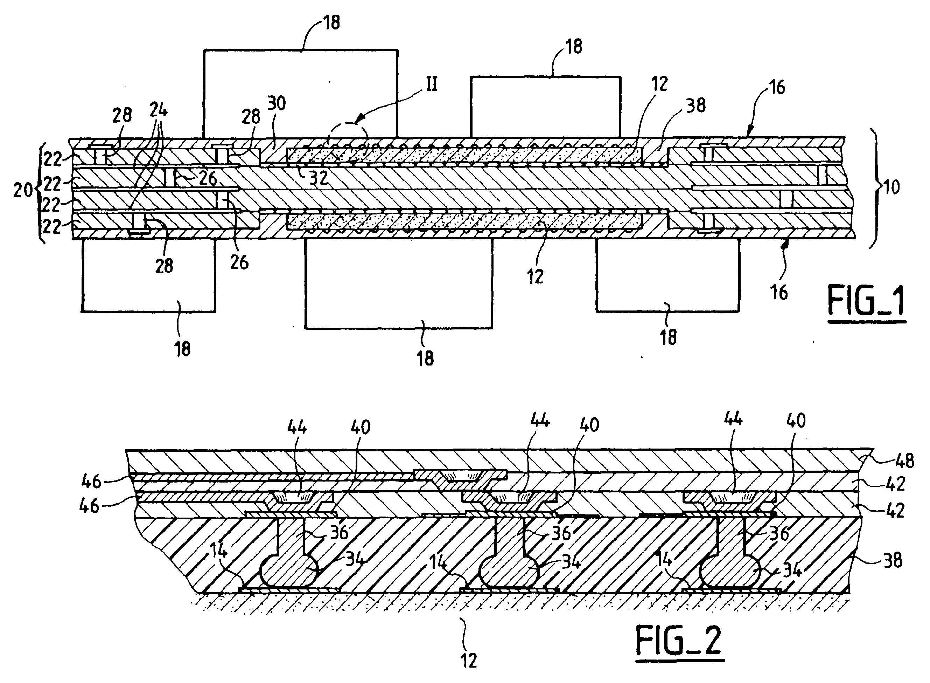

Sur la figure 1, la référence 10 désigne de façon générale un circuit électronique réalisé selon les enseignements de l'invention, qui est dans cet exemple un circuit double face comportant sur chacune de ses faces une ou plusieurs puces de circuit intégré 12 ainsi que, reportés sur la surface 16, divers composants discrets 18, actifs ou passifs, par exemple des composants CMS.

De façon caractéristique de l'invention, les puces 12 sont des puces nues, c'est-à-dire des plaquettes directement issues de la tranche de silicium après découpe de celle-ci en composants individuels, sans traitement supplémentaire, enrobage ni encapsulation.

Les puces 12 comportent en surface des plages de contact ou *pads* 14 (visibles sur le détail de la figure 2) tournées vers le haut ; on exposera plus loin la manière dont est réalisée la prise de contact à ces plages 14.

Le circuit est réalisé sur un substrat 20 qui, dans cet exemple, est un substrat multicouche incorporant une pluralité de couches isolantes 22 portant des métallisations conductrices 24 reliées entre elles par des vias internes 26, et à des métallisations de surface par des vias externes 28. Ce substrat 20 est un substrat de type classique, généralement réalisé en verre époxy, polyimide ou équivalent.

De façon également caractéristique de l'invention, ce substrat comporte (dans cet exemple, sur chacune de ses faces) une ou plusieurs cavités 30 dont les dimensions, en surface et en épaisseur, sont légèrement supérieures à celles des puces 12 que ces cavités sont destinées à recevoir. Les cavités peuvent être réalisées par enlèvement de matière, c'est-à-dire par usinage du substrat multicouche après réalisation de celui-ci, ou bien directement au moment de la formation de l'empilement de couches, en prévoyant alors pour la dernière couche une découpe de la taille voulue, qui formera la cavité après superposition aux autres couches, restées pleines.

La puce 12 est mise en place au fond de la cavité 30 avec interposition d'une épaisseur 32 de colle (par exemple une colle avec trame), permettant de parfaitement maîtriser le positionnement en épaisseur de la puce dans la cavité.

Une fois collée au fond de la cavité, la puce reçoit sur chacune de ses plages de contact 14 une série de liaisons électriques, par exemple sous forme d'une boule 34 prolongée par une queue verticale 36. Cette prise de contact est réalisée par une technique exposée dans le WO-A-93/24956, dont la demanderesse est co-titulaire et auquel on pourra se référer pour de plus amples détails sur la réalisation des liaisons électriques.

La cavité 30 est ensuite remplie d'une résine 38, en une quantité qui permet d'enterrer complètement la puce, à l'exception des queues 36 des fils de liaison aux plages de contact 14.

Le matériau de la résine 38 est un matériau tel qu'un polyimide, une polyphénylquinoxaline, un polysiloxane, une résine époxy ou analogue. Son coefficient de dilatation est choisi pour être le même que celui du matériau du substrat (par exemple 19 ppm pour un substrat en verre époxy), et il est coulé et durci *in situ*, par exemple par exposition aux UV ou passage en température.

Après durcissement de la résine, le substrat pourvu des puces enterrées est soumis, à une opération de polissage ou rectification de manière à ajuster l'état de surface et couper les queues 36 au ras de la surface obtenue.

L'étape suivante est une étape de dépôt d'une couche de métallisation (par exemple de nickel), qui est gravée pour réaliser les prises de connexion 40 sur chacune des queues 36, toujours de la manière enseignée par le WO-A-93/24956 précité.

Le circuit obtenu peut éventuellement recevoir, notamment au-dessus des puces, des couches d'interconnexion supplémentaires réalisées selon la technique dite des "micro-vias". Cette technique consiste à déposer des couches 42 de matériau isolant qui sont gravées pour former des prises de contact 44 traversant l'épaisseur de la couche et reliées à des conducteurs métalliques 46. On peut ainsi superposer plusieurs couches pour augmenter la densité de routage du motif d'interconnexion du circuit.

L'ensemble reçoit enfin une couche finale 48 qui sera la couche de surface du substrat, et sur laquelle seront reportés les composants discrets 18, généralement des composants CMS.

Avantageusement, les diverses étapes que l'on vient d'exposer ci-dessus sont opérées sur une plaque de substrat de grande dimension, correspondant à une pluralité de circuits individuels réalisés collectivement et qui seront individualisés ultérieurement par découpe de la plaque.

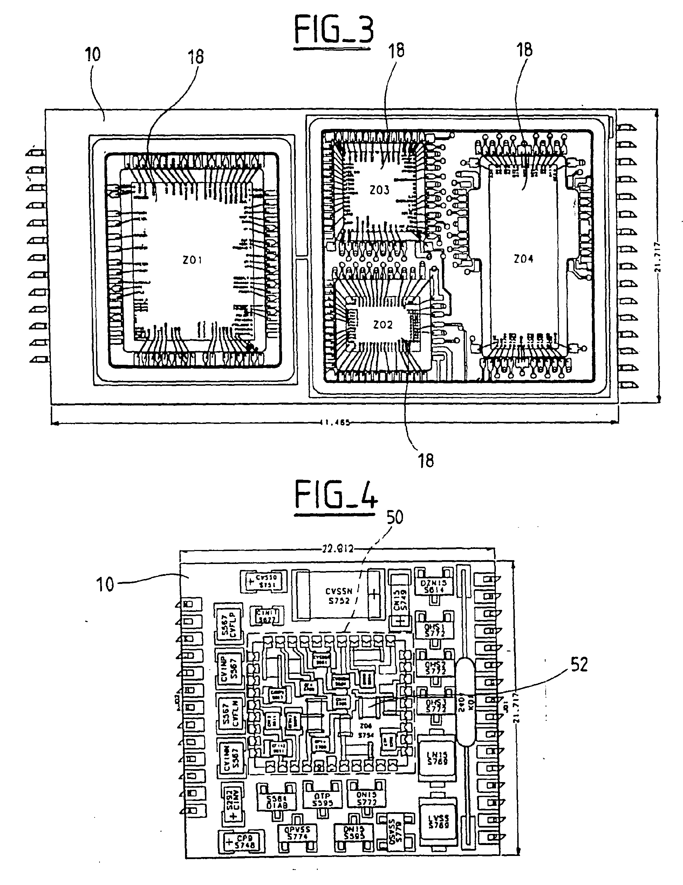

La figure 3 est une vue en plan de l'une des faces d'un circuit 10 réalisé conformément aux enseignements de l'art antérieur. Il s'agit d'un circuit double face, où l'une des faces porte les circuits intégrés sous forme de composants encapsulés 18 (au nombre de quatre dans l'exemple illustré) et l'autre face (non visible sur la figure) porte les divers composants discrets. La surface d'un tel circuit est de l'ordre de 900 mm².

La figure 4 montre, à titre de comparaison, le même circuit réalisé selon les enseignements de l'invention. Il s'agit toujours d'un circuit double face, mais les puces sont enterrées des deux côtés du circuit, et les composants discrets sont reportés sur les deux côtés du circuit, également. La face du circuit visible figure 4 porte la puce qui était celle du circuit de gauche sur la figure 3, mais celle-ci est désormais enterrée dans l'épaisseur du substrat (le contour 50 en tiretés illustre sa position) et recouverte de composants discrets tels que 52, reportés au-dessus de cette puce. L'autre face du circuit porte les trois autres puces, ainsi que d'autres composants discrets.

Grâce à la technologie mise en oeuvre selon l'invention, il est possible de réduire la surface du substrat de 900 à 495 mm², soit un gain de 45 %, avec le même nombre de composants, les mêmes puces et donc exactement les mêmes fonctionnalités que le circuit de l'art antérieur.

On notera que, outre le gain en surface, l'invention procure un gain en épaisseur de l'ordre de 30 %, grâce à la suppression des boîtiers des puces et à l'incorporation de celles-ci dans l'épaisseur du substrat. Le gain total en volume peut alors atteindre 60 %.

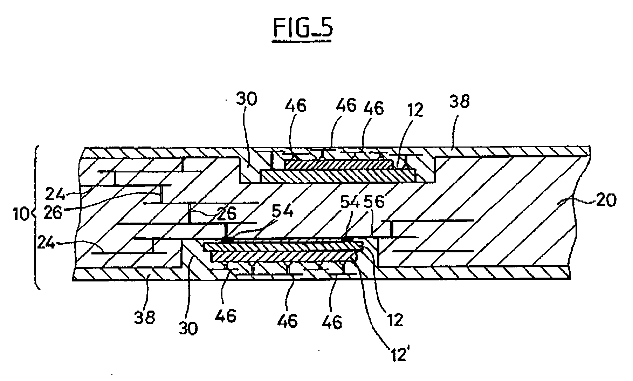

Sur la figure 5, on a illustré une variante de mise en oeuvre de l'invention, dans laquelle plusieurs puces sont enterrées dans une même cavité 30. La figure 5 illustre aussi, incidemment, la possibilité d'enterrer des puces sur les deux faces du substrat 10, en y formant des cavités correspondantes 30.

Par exemple, on peut empiler l'une sur l'autre deux puces 12 et 12', en prévoyant des prises de connexion appropriées aux plages de contact des puces.

Divers modes de prise de connexion sont possibles. Ainsi, dans le cas des puces 12, 12' placées dans la cavité supérieure (avec les conventions de la figure) du substrat 20, les puces ont toutes deux leur face portant les plages de contact tournée vers l'extérieur (c'est-à-dire vers l'ouverture de la cavité 30), et les prises de contact avec la puce intérieure 12 se font par des plages de contact situées à la périphérie de cette dernière. On peut de cette manière relier les plages de contact des puces avec des contacts en surface en empilant des puces de dimensions progressivement décroissante (configuration "en pièce montée") ou configurées de tout autre manière appropriée, procurant ainsi une réduction de surface totale encore plus importante (le cas échéant au prix d'une légère augmentation de l'épaisseur du substrat).

Dans le cas des puces 12, 12' placées dans la cavité inférieure, on a illustré (à titre d'exemple) une autre configuration, où la puce intérieure 12 a ses plages de contact tournées vers l'intérieur, c'est-à-dire vers le substrat, et la puce extérieure 12' ses plages de contact tournées vers l'extérieur (les deux puces 12, 12' sont donc montées dos à dos). La prise de contact aux plots de la puce extérieure 12' est effectuée comme précédemment, en revanche la prise de contact aux plots de la puce intérieure 12 est effectuée en 54 directement à des métallisations internes 56 du substrat qui émergent dans la cavité 30. La liaison électrique en 54 peut être réalisée par des techniques connues telles que colle conductrice, "flip-chip", "ball-bonding", etc. La puce extérieure 12' est ensuite posée sur la puce intérieure 12 après réalisation de ces liaisons électriques, et sa liaison électrique est réalisée comme indiqué plus haut. L'enrobage final maintient les puces en place.

De façon générale, l'empilement de plusieurs puces dans une même cavité présente, outre la réduction de la surface occupée, de nombreux avantages en termes de conception des circuits. Ainsi, on peut simplifier le routage par rapport à des puces placées côte à côte lorsque des techniques photolithographiques sont employées pour la réalisation des conducteurs ; de plus, les tolérances de positionnement de deux puces 12 et 12' superposées sont moindres que si ces puces avaient été placées côte à côte sur le substrat.

## Revendications

1. Un procédé de report d'une pluralité de puces de microcircuit sur un substrat destiné à recevoir ces puces ainsi que d'autres composants électroniques associés pour former un circuit électronique, notamment le circuit électronique d'un dispositif médical implantable actif tel qu'un stimulateur ou défibrillateur cardiaque, comprenant les étapes suivantes :
a) obtention de puces nues individualisées (12) portant sur l'une de leurs faces des plages de contact électrique (40) ;
b) obtention d'un substrat (20) incorporant en son sein des motifs d'interconnexion ;
c) mise en place des puces sur le substrat ;
d) report sur les plages de contact des puces de fils de liaison électrique (34, 36) émergeant au-dessus du niveau du substrat ;
e) application sur le substrat d'une résine isolante (38) recouvrant les puces en laissant des fils de liaison émergents ;
f) réalisation de connexions électriques entre les fils de liaison émergents et ledit motif d'interconnexion (24, 26, 28) du substrat ; et
g) report sur le substrat desdits composants supplémentaires associés (18),
procédé **caractérisé en ce que** :
- le substrat obtenu à l'étape b) comporte sur au moins l'une de ses faces au moins une cavité (30) de profondeur et d'étendue supérieures à celles desdites puces ;
- à l'étape c) une pluralité de puces (12, 12') sont superposées dans la même cavité ; et
- à l'étape e) la cavité est remplie par la résine isolante (38) affleurant le plan du substrat.

2. Le procédé de la revendication 1, dans lequel, à l'étape c), au moins une puce est disposée avec ses plages de contact tournées vers l'extérieur.

3. Le procédé de la revendication 1, dans lequel au moins certains des composants supplémentaires de l'étape g) sont reportés au-dessus des puces.

4. Le procédé de la revendication 1, dans lequel l'étape c) comporte le collage d'une puce au fond de la cavité au moyen d'un film de colle (32) d'épaisseur contrôlée.

5. Le procédé de la revendication 1, dans lequel l'étape f) comporte la formation au-dessus des puces d'une pluralité de couches d'interconnexion supplémentaires (42, 44, 46).

6. Le procédé de la revendication 1, dans lequel les étapes b) à g) sont accomplies collectivement sur une plaque de substrat unique portant une pluralité de circuits électroniques, et sont ensuite suivies d'une étape de découpe du substrat pour l'individualisation de ces circuits électroniques.

7. Un circuit électronique, notamment le circuit électronique d'un dispositif médical implantable actif tel qu'un stimulateur ou défibrillateur cardiaque, comportant:
- un substrat (20) ;
- reportés sur le substrat, une pluralité de puces ainsi que d'autres composants électroniques associés (18), les puces étant des puces nues non encapsulées portant des plages de contact électrique (40); et
- une résine isolante (38) recouvrant les puces à l'exception de fils de liaison reliés à un motif d'interconnexion (24, 26, 28) disposé au sein du substrat,
circuit **caractérisé en ce que** :
- le substrat comporte sur au moins l'une de ses faces au moins une cavité (30) de profondeur et d'étendue supérieures à celles desdites puces, cette cavité étant remplie par la résine isolante (38) affleurant le plan du substrat ; et
- une pluralité de puces (12, 12') sont superposées dans ladite cavité (30) et sont enterrées dans l'épaisseur du substrat au fond de cette cavité.

8. Le circuit électronique de la revendication 7, dans lequel au moins certains des composants supplémentaires sont reportés au-dessus de la puce.

9. Le circuit électronique de la revendication 7, comprenant au-dessus de la puce une pluralité de couches d'interconnexion supplémentaires (42, 44, 46).

10. Le circuit électronique de la revendication 7, dans lequel deux puces superposées (12, 12') sont placées dans ladite cavité (30) avec toutes deux leur face portant les plages de contact tournée vers l'ouverture de la cavité.

11. Le circuit électronique de la revendication 10, dans lequel les plages de contact de la puce intérieure (12) sont situées à la périphérie de cette dernière.

12. Le circuit électronique de la revendication 10, dans lequel les puces empilées dans ladite cavité (30) sont des puces présentant des dimensions progressivement décroissantes.

13. Le circuit électronique de la revendication 7, dans lequel deux puces superposées (12, 12') placées dans ladite cavité (30) sont montées dos à dos, l'une (12) avec ses plages de contact tournées vers le substrat et l'autre (12') avec ses plages de contact tournées vers l'extérieur.

14. Le circuit électronique de la revendication 13, dans lequel les plages de contact de la puce extérieure (12') sont situées à la périphérie de cette dernière, et les plages de contact de la puce intérieure (12) sont reliées directement à des métallisations internes (56) du substrat, qui émergent dans la cavité (30).

## Claims

1. A method for placing a plurality of microcircuit chips on a substrate adapted to support said chips along with other electronic components associated thereto in order to provide an electronic circuit, in particular the electronic circuit of an active implantable medical device such as a cardiac pacemaker or defibrillator, comprising the following steps:
a) providing individual bare chips (12) having electrical contact pads (40) on one of their surfaces;
b) providing a substrate (20) having interconnection patterns embedded therein;
c) setting the chips onto the substrate;
d) placing on the contact pads of the chips electrical connection threads (34, 36) which protrude over the level of the substrate;
e) applying onto the substrate an insulating resin (38) covering the chips, while letting the connection threads protrude;
f) making electrical connections between the protruding connection threads and said interconnection pattern (24, 26, 28) of the substrate ; and
g) placing said associated additional electronic components (18) onto the substrate,
said method being **characterised in that**:
- the substrate provided in step b) includes on at least one of its surfaces at least one cavity (30) the depth and area of which are larger than those of the chips;
- in step c) a plurality of chips (12, 12') are superimposed within the same cavity; and
- in step e) the cavity is filled by the insulating resin (38) flush with the plane of the substrate.

2. The method of claim 1, wherein in step c) at least one chip is arranged having its contact pads turned towards the outside.

3. The method of claim 1, wherein at least some of the additional components of step g) are placed on top of the chips.

4. The method of claim 1, wherein step c) includes the bonding of a chip to the bottom of the cavity by means of a film of glue (32) having a controlled thickness.

5. The method of claim 1, wherein step f) includes making a plurality of additional interconnection layers (42, 44, 46) over the chips.

6. The method of claim 1, wherein steps b) to g) are collectively performed on a single substrate plate supporting a plurality of electronic circuits, and are followed by a step of cutting the substrate in order to individualize said electronic circuits.

7. An electronic circuit, in particular the electronic circuit of an active implantable medical device such as a cardiac pacemaker or defibrillator, comprising :
- a substrate (20);
- supported on the substrate, a plurality of chips and other associated electronic components (18), the chips being non-embedded bare chips having electrical contact pads (40); and
- an insulating resin (38) covering the chips except for connection threads connected to an interconnection pattern (24, 26, 28) provided within the substrate;
said circuit being **characterised in that**:
- the substrate includes on at least one of its surfaces at least one cavity (30) the depth and area of which are larger than those of said chips, said cavity being filled by the insulating resin (38) flush with the plane of the substrate; and
- a plurality of chips (12, 12') are superimposed within said cavity (30) and are buried across the thickness of the substrate on the bottom of said cavity.

8. The electronic circuit of claim 7, wherein at least some of the additional components of step g) are placed on top of the chip.

9. The electronic circuit of claim 7, including a plurality of additional interconnection layers (42, 44, 46) over the chip.

10. The electronic circuit of claim 7, wherein two superimposed chips (12, 12') are placed in said cavity (30), both having their surface supporting the contact pads which is turned towards the opening of the cavity.

11. The electronic circuit of claim 10, wherein the contact pads of the innermost chip (12) are located at the periphery thereof.

12. The electronic circuit of claim 10, wherein the chips stacked within said cavity (30) are chips having successive smaller dimensions.

13. The electronic circuit of claim 7, wherein two superimposed chips (12, 12') are arranged back-to-back in said cavity (30), one (12) having its contact pads turned towards the substrate and the other one (12') having its contact pads turned towards the outside.

14. The electronic circuit of claim 13, wherein the contact pads of the outermost chip (12') are located at the periphery thereof, whereas the contact pads of the innermost chip (12) are directly connected to internal substrate metallizations (56) protruding in the cavity (30).

## Patentansprüche

1. Verfahren zum Setzen einer Mehrzahl von Mikroschaltungschips auf ein Substrat, das dazu bestimmt ist, diese Chips sowie andere zugeordnete elektronische Komponenten aufzunehmen, um eine elektronische Schaltung zu bilden, insbesondere die elektronische Schaltung einer aktiven implantierbaren medizinischen Vorrichtung, wie z.B. ein Herzschrittmacher oder Defibrillator, mit den folgenden Schritten:
a) Erhalten von nackten individualisierten Chips (12), die auf einer ihrer Seiten Bereiche (40) für einen elektrischen Kontakt tragen;
b) Erhalten eines Substrats (20), das in seinem Innern Zwischenverbindungsmuster einschließt;
c) Anordnung der Chips auf dem Substrat;
d) Setzen von Drähten (34, 36) zur elektrischen Verbindung, die über die Höhe des Substrats hinausragen, auf die Kontaktbereiche der Chips;
e) Anwendung eines Isolierharzes (38) auf das Substrat, das die Chips bedeckt, wobei es Verbindungsdrähte herausragen lässt;
f) Verwirklichung von elektrischen Verbindungen zwischen den herausragenden Verbindungsdrähten und dem Zwischenverbindungsmuster (24, 26, 28) des Substrats; und
g) Setzen der zugeordneten zusätzlichen Komponenten (18) auf das Substrat,
Verfahren, dass **dadurch gekennzeichnet ist, dass**:
- das beim Schritt b) erhaltene Substrat auf mindestens einer seiner Seiten wenigstens eine Vertiefung (30) mit einer Tiefe und einem Ausmaß umfasst, die größer als diejenigen der Chips sind;
- beim Schritt c) eine Mehrzahl von Chips (12, 12') in derselben Vertiefung übereinander gesetzt werden; und
- beim Schritt e) die Vertiefung mit dem Isolierharz (38) gefüllt wird, das mit der Substratebene bündig ist.

2. Verfahren nach Anspruch 1, bei welchem beim Schritt c) wenigstens ein Chip mit nach außen gewandten Kontaktbereichen angeordnet wird.

3. Verfahren nach Anspruch 1, bei welchem zumindest bestimmte der zusätzlichen Komponenten des Schritts g) über die Chips gesetzt werden.

4. Verfahren nach Anspruch 1, bei welchem der Schritt c) das Kleben eines Chips am Boden der Vertiefung mittels eines Klebstofffilms (32) von kontrollierter Dicke umfasst.

5. Verfahren nach Anspruch 1, bei welchem der Schritt f) das Ausbilden einer Mehrzahl zusätzlicher Zwischenverbindungsschichten (42, 44, 46) über den Chips umfasst.

6. Verfahren nach Anspruch 1, bei welchem die Schritte b) bis g) gemeinsam auf einer einzigen Substratplatte ausgeführt werden, die eine Mehrzahl elektronischer Schaltungen trägt, und anschließend von einem Schritt des Zerschneidens des Substrats zur Individualisierung dieser elektronischen Schaltungen gefolgt werden.

7. Elektronische Schaltung, insbesondere die elektronische Schaltung einer aktiven implantierbaren medizinischen Vorrichtung, wie z.B. ein Herzschrittmacher oder Defibrillator, mit:
- einem Substrat (20);
- einer Mehrzahl Chips sowie anderen zugeordneten elektronischer Komponenten (18), die auf das Substrat gesetzt sind, wobei die Chips nackte nicht verkapselte Chips sind, die Bereiche (40) für einen elektrischen Kontakt tragen; und
- einem Isolierharz (38), das die Chips mit Ausnahme von Verbindungsdrähten bedeckt, die mit einem Zwischenverbindungsmuster (24, 26, 28) verbunden sind, das im Innern des Substrats angeordnet ist,
Schaltung, die **dadurch gekennzeichnet ist, dass**:
- das Substrat auf mindestens einer seiner Seiten wenigstens eine Vertiefung (30) mit einer Tiefe und einem Ausmaß umfasst, die größer als diejenigen der Chips sind, wobei diese Vertiefung mit dem Isolierharz (38) gefüllt ist, das mit der Substratebene bündig ist; und
- eine Mehrzahl Chips (12,12') in der Vertiefung (30) übereinander gesetzt und in der Dicke des Substrats am Boden dieser Vertiefung vergraben sind.

8. Elektronische Schaltung nach Anspruch 7, bei welcher zumindest bestimmte der zusätzlichen Komponenten über den Chip gesetzt sind.

9. Elektronische Schaltung nach Anspruch 7, mit einer Mehrzahl zusätzlicher Zwischenverbindungsschichten (42, 44, 46) über dem Chip.

10. Elektronische Schaltung nach Anspruch 7, bei welcher zwei übereinander gesetzte Chips (12, 12') in der Vertiefung (30) angeordnet sind, wobei bei beiden die die Kontaktebereiche tragende Seite zur Öffnung der Vertiefung hin gewandt ist.

11. Elektronische Schaltung nach Anspruch 10, bei welcher die Kontaktbereiche des inneren Chips (12) sich an der Peripherie des letzteren befinden.

12. Elektronische Schaltung nach Anspruch 10, bei welcher die in der Vertiefung (30) gestapelten Chips Chips sind, die nach und nach abnehmende Ausmaße aufweisen.

13. Elektronische Schaltung nach Anspruch 7, bei welcher zwei übereinander gesetzte in der Vertiefung (30) angeordnete Chips (12, 12') mit dem Rücken zueinander montiert sind, der eine (12) mit zum Substrat hin gewandten Kontaktbereichen, und der andere (12') mit nach außen gewandten Kontaktbereichen.

14. Elektronische Schaltung nach Anspruch 13, bei welcher die Kontaktbereiche des äußeren Chips (12') sich an der Peripherie des letzteren befinden, und die Kontaktbereiche des inneren Chips (12) direkt mit internen Metallisierungen (56) des Substrats verbunden sind, die in die Vertiefung (30) hineinragen.
